(19)

Europäisches
Patentamt
European
Patent Office
Office européen
des brevets

(11) **EP 3 961 237 A1**

(12) **EUROPEAN PATENT APPLICATION**

(43) Date of publication:
**02.03.2022 Bulletin 2022/09**

(21) Application number: **20192312.5**

(22) Date of filing: **24.08.2020**

(51) International Patent Classification (IPC):
***G01R 33/483*** (2006.01)     ***G01R 33/48*** (2006.01)

(52) Cooperative Patent Classification (CPC):
**G01R 33/483; G01R 33/4804**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Koninklijke Philips N.V.
5656 AG Eindhoven (NL)**

(72) Inventors:
- **LAMERICHS, Rudolf Mathias Johannes Nicolaas
  5656 AE Eindhoven (NL)**
- **WESTERINK, Joanne Henriëtte Desirée Monique
  5656 AE Eindhoven (NL)**

- **LEUFKENS, Timmy Robertus Maria
  5656 AE Eindhoven (NL)**
- **HUIJBERS, Willem
  5656 AE Eindhoven (NL)**
- **VAN EE, Raymond
  5656 AE Eindhoven (NL)**
- **DENISSEN, Adrianus Johannes Maria
  5656 AE Eindhoven (NL)**
- **MATTERS, Marco
  5656 AE Eindhoven (NL)**

(74) Representative: **Philips Intellectual Property &
Standards
High Tech Campus 52
5656 AG Eindhoven (NL)**

(54) **MRI SYSTEMS AND METHODS FOR INDICATING BRAIN TISSUE DAMAGE OF A SUBJECT**

(57)     The invention provides concepts for indicating brain tissue damage or neuro-inflammation using MR thermometry. In particular, it is proposed that MR thermometry may be employed to determine a variation in the water PRF across a plurality of differently-timed MRI images (captured during an imaging time window) and such a variation may be used to determine an indication of brain tissue damage or neuro-inflammation.

FIG. 1

**Description**

FIELD OF THE INVENTION

The invention relates to medical assessment of human subjects, and more particularly to the field of investigating tissue damage of a brain of a subject.

BACKGROUND OF THE INVENTION

In the psychiatric and neurology community, there has been increased interest in investigating tissue damage of the brain by imaging inflammatory processes in the brain (i.e. neuroinflammatory processes) and the associated condition of the blood-brain-barrier (BBB). Neuroinflammatory processes are associated with disturbances in the BBB, and these disruptions may play an important role in the onset of neurological disorders such as multiple sclerosis. Thus, there are indications that neuro-inflammatory processes in the brain are associated with and predictors of various pathologies and mental disorders.

A known approach to detecting the presence of neuroinflammatory processes (and the associated disturbance of the blood-brain-barrier) is by locally measuring an elevated temperature in the brain. This is premised on the basis that neuroinflammation is accompanied with local temperature rises. Specifically, it is expected that the local temperature is increased in brain areas with neuroinflammation and that the temperature regulation of these areas is affected.

Brain temperature can be measured by Magnetic Resonance (MR) thermometry. Magnetic Resonance Imaging (MRI) images are based on measuring the water protons in soft-tissues. The RF signal of the water is detected and the resonant frequency $\omega_0$ of the signal depends mainly on the external magnetic field as described in Equation 1:

$$\omega_0 = \gamma B_0 \tag{1},$$

wherein $\gamma$ is gyromagnetic ratio of the spinning nucleus in an external magnetic field, a constant for a given nucleus (H1: 42.58 MHz/T), and $B_0$ is the strength of that magnetic field, typically 1.5 or 3 Tesla.

It is known that the resonance frequency ($\omega_0$) of the water proton signal (i.e. water Proton Resonance Frequency, or 'water PRF') changes as function of the temperature. Based on this understanding, proton resonance frequency (PRF) thermometry has been used to measure temperature changes induced by external sources such as focused ultra sound (HIFU).

However, using only the $\omega_0$ (of the water protons) (i.e. water PRF) as a direct measure for absolute temperature is not possible due to residual inhomogeneity of the external magnet and local variation in $\omega_0$ caused by susceptibility. That is, using the water protons only will lead to incorrect temperature readings.

As an alternative approach to investigating tissue damage of the brain, it is known to assess the BBB integrity (which is associated with neuroinflammation) by means of MRI scanning of the Gadolinium uptake in the brain, DCE-MRI5. However, this technique requires high doses of Gadolinium-based contrast agents and the safety of these agents is debated.

SUMMARY OF THE INVENTION

The invention is defined by the claims.

According to examples in accordance with an aspect of the invention, there is provided a method for indicating tissue damage of a subject's brain, the method comprising:

obtaining a plurality of MRI images of the subject's brain, each MRI image being captured at a different time within an imaging time window;
for each of the plurality of MRI images, determining the water Proton Resonance Frequency, PRF, for a region of interest of the subject's brain;
determining a variation in the water PRF across the plurality of MRI images; and
determining an indication of tissue damage in the region of interest of the subject's brain based on the determined variation in the water PRF.

It is proposed that a variation in the water PRF across a plurality of MRI images of the same brain region (from an imaging time window) may be used to determine an indication of brain tissue damage. Such variations can cause differences in the phase and thus be measured as phase variations between subsequent acquisitions. Such proposals that assess or analyze variations in brain temperature may be based on the idea that brain regions/areas with inflammatory activity will exhbihit temperature flucations/variations that differ from other areas/regions of the brain.

Embodiments may employ MR thermometry as a diagnostic tool. In particular, embodiments may detect (local) fluctuations in brain temperature over time and infer such fluctuations as being a sign of inflammation. Thus, there may be provided a diagnostic tool for neurological and mental disorders. Such a tool may have the benefit that assessment of brain temperature information for diagnosis can be undertaken earlier and more precisely than conventional methods.

By way of example, it is expected that there will be an interaction effect with brain tissue inflammation when a specific task (that activates the brain tissue at hand) is presented or needs to be conducted (i.e. it is expected that brain temperature rises while executing a task), and the inventors propose that an area of the brain with tissue damage might exhibit a difference in temperature increase. In this way, proposed embodiments may enable more precise identification and/or localization of an affected brain region/area. Further, temperature variations may even be associated with a specific (mental or behavioral) deficit, and thus enable more precise diagnosis.

Put another way, the inventors propose that, in brain areas with inflammatory activity, temperature variations will differ from the rest of brain. This is based on the idea that brain temperature is controlled through a 'feedback' mechanism - The blood flow will 'cool' the brain (due to brain temperature being higher than the core body temperature), and so cooler blood enters the brain. In areas with tissue inflammation, the homeostasis may be different. As a result, the temperature fluctuation(s) in damaged brain tissue is expected to have higher peaks as compared to the normal variations. Also, it may be that the frequency of the fluctuations is different.

It is proposed that temperature fluctuations are reflected as (local) variations of the water PRF. Such variations can cause differences in the phase and be measured as phase variations between subsequent acquisitions. Embodiments propose the use of MRI-based measurements of brain temperature (temporal fluctuations) for the detection of neuroinflammation, which may provide an indication of brain tissue damage or (mental) disorders. Proposed temperature variation assessment concepts may therefore provide new and/or useful diagnostic information, thus providing improved clinical decision support.

An advantage of the proposed MRI-based concept(s) is that the use of MR thermometry may detect problems in the BBB in a non-invasive manner. For example, embodiments may avoid a need to use potentially unsafe contrast agents.

Purely by way of example, embodiments may employ a MRI scanner running dedicated MRI sequences that are tuned to measure temperature fluctuations. Such a scanner may, for example, comprise a 3T MRI scanner.

Also, some embodiments may employ dedicated MR thermometry software that is configured to process the MRI data to establish information about the temperature in the various regions of a subject's brain. Such information may comprise information relating to the (relative) fluctuation of the temperature in each of a plurality of brain regions. The information may further comprise information relating to the absolute local temperature in each of a plurality of brain regions (e.g. using an internal reference parameter and methods to correct for susceptibility artifacts).

In an embodiment, determining a variation in the water PRF may comprise: determining a baseline water PRF for the plurality of MRI images; and determining a relative variation in the water PRF with respect to the baseline water PRF. For example, determining a relative variation in the water PRF may comprise determining a maximum deviation of the water PRF from the baseline water PRF across the plurality of MRI images. Such a deviation may be in considered in terms of an absolute deviation, i.e. the maximum positive or negative deviation from the baseline.

In some embodiments, determining an indication of tissue damage of the region of interest of the subject's brain may comprise: comparing the determined variation in the water PRF against a variation threshold value; and determining an indication of tissue damage in the region of interest of the subject's brain based on the comparison result. Use of a variation threshold value may enable small varations or fluctuations (i.e. noise or normal/exptected variations) to be ignored, thus improving accuracy (e.g. by avoiding false positives).

By way of example, the variation threshold value may be based on at least one of: a characteristic of blood flow in the subject's brain; medication taken by the subject; the region of interest; a physiological property of the subject; a medical condition of the subject; a medical history of the subject. For instance, defects in blood flow may affect the threshold, and such defects may be determined using MR angiography and/or brain perfusion (ASL). Medication can also have effects, either on metabolic changes or blood flow. Also, in a healthy subject, the threshold may differ over various regions/areas of the brain. For example, cooler blood enters the brain at the base and will become warmer, and a dorso-ventral temperature gradient has thus been suggested (which may therefore be accounted for in setting a variation threshold value).

Some embodiments may also comprise determining a value of absolute temperature of the region of interest of the subject's brain. The process of the determining an indication of tissue damage of the region of interest of the subject's brain may then be further based on the determined value of absolute temperature of the region of interest of the subject's brain.

It is proposed that embodiments may employ two main concepts for indicating brain tissue damage. The first is that of using a variation in water Proton Resonance Frequency (PRF) over time to identify tissue damage (e.g. inflammation). The second concept is that of identifying an absolute temperature based on a difference between the water PRF and an internal reference PRF (e.g. the PRF of brain metabolite that behaves differently from the water PRF as function of the temperature). Preferably, the internal reference PRF may be independent of temperature. For example, determining a value of absolute temperature of the region of interest may comprise determining a value of absolute temperature based on a difference between the water PRF and an internal reference resonance frequency. The internal reference resonance frequency may, for example, comprise the resonance frequency of one of: Creatine; Choline; NAA; and a non-water brain metabolite.

Put another way, the internal reference may be one that behaves differently from the water PRF as function of the temperature. In the brain, NAA is used or other brain metabolites such as choline.

Such a proposed combination of absolute and relative temperature assessment methods may provide detailed and accurate diagnostic information.

According to examples in accordance with yet another aspect of the invention, there is provided a computer program product comprising computer program code means which, when executed on a computing device having a processing system, cause the processing system to perform all of the steps of the method described above.

According to examples in accordance with another aspect of the invention, there is provided a system for indicating tissue damage of a subject's brain, the system comprising:

- an interface component configured to obtain a plurality of MRI images of the subject's brain, each MRI image being captured at a different time within an imaging time window;
- a Proton Resonance Frequency component configured to, for each of the plurality of MRI images, determine the water Proton Resonance Frequency, PRF, for a region of interest of the subject's brain; and
- an analysis component configured to determine a variation in the water PRF across the plurality of MRI images, and to determine an indication of tissue damage of the region of interest of the subject's brain based on the determined variation in the water PRF.

These and other aspects of the invention will be apparent from and elucidation with reference to the embodiment(s) described hereinafter.

BRIEF DESCRIPTION OF THE DRAWINGS

For a better understanding of the invention, and to show more clearly how it may be carried into effect, reference will now be made, by way of example only, to the accompanying drawings, in which:

Fig. 1 shows a simplified block diagram of a system according to an embodiment; and
Fig. 2 depicts a flow diagram of a method for indicating tissue damage of a subject's brain according to an embodiment.

DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides concepts for indicating brain tissue damage or neuro-inflammation using MR thermometry. In particular, it is proposed that MR thermometry may be employed to determine a variation in the water PRF across a plurality of differently-timed MRI images (from an imaging time window) and such a variation may be used to determine an indication of brain tissue damage or neuro-inflammation.

Embodiments may thus employ MR thermometry as a diagnostic tool for detecting fluctuations/variations in brain temperature with respect to time, from which indications of brain tissue damage or inflammation may be inferred. Such embodiments may provide the benefit that assessment of brain tissue damage may be undertaken earlier and more precisely than conventional methods. Improved clinical decision support may therefore me provided by proposed embodiments.

By way of initial explanation, an exemplary embodiment may use MR thermometry to obtain an indication of (relative) temperature fluctuations over time (from which an indication of brain tissue damage may be derived).

Although proton-based MR thermometry may not provide a reliable indication of absolute temperature, the inventors have realized that MR thermometry may be used to obtain an indication of relative local temperature fluctuations in the brain of a subject. It is further proposed that such temperature fluctuations are indicative of brain tissue damage or inflammation.

By way of example, in one proposed embodiment, a plurality of MRI images is obtained for an imaging time window. For instance, in one example, an MRI image is recorded every 0.5 seconds and the total imaging time is in the order of 5-10 minutes. A first (baseline) set of images is used as a baseline reference, and water PRF ($\omega_0$) changes in the subsequent images with respect to the reference image(s) reflect the temperature fluctuation.

It is proposed that a large variation in temperature indicates the absence of adequate temperature regulation, and from such disrupted regulation one or more areas of neuroinflammation can be inferred. It is also proposed that a secondary indicator is the speed (or rate) of the temporal variation - In affected regions of the brain, either a faster or slower variation may be observed.

An exemplary implementation comprises specifying the relative water PRF $\omega_0$ variation V in terms of a percentage from the baseline value of $\omega_0$ according to equation 2 as follows:

$$V=100\%*st.dev(\omega_0)/\omega_{0,baseline} \qquad (2)$$

The variance Var across a time window $\Delta T$ can be determined according to equation 3 as follows:

$$Var(\Delta T) = \frac{1}{n} \sum_i^n (\Delta T_i - \overline{\Delta T})^2 \qquad (3),$$

wherein $\overline{\Delta T}$ = mean value for the time window $\Delta T$, and n = number of images.

The value of V then provides an indication of the disturbance of the temperature regulation in the imaged brain tissue (and thus indicates a severity of neuroinflammation).

A variation threshold value for V can be defined (e.g. 20%) to identify notable or relevant cases (e.g. those for which V exceeds the variation threshold value). The variation threshold value may be based on one or more various aspects relating to the subject, such as a characteristic of blood flow in the subject's brain, medication taken by the subject, the brain region of interest, a physiological property of the subject, or a medical condition of the subject; a medical history of the subject. For instance, defects in blood flow may affect the threshold, and such defects may be determined using MR angiography and/or brain perfusion (ASL). Medication can also have effects, either metabolic changes or blood flow. Also, in a healthy subject, the threshold may differ over various regions/areas of the brain. For example, cooler blood enters the brain at the base and will become warmer, and a dorso-ventral temperature gradient has thus been suggested (which may be accounted for in setting a threshold value).

By taking the relative variation in $\omega_0$, values of V may be comparable between different brain regions, even if the absolute values of $\omega_0$-derived temperature vary across different brain regions.

Other well-known measures of variation may be used, e.g. inter-quartile range, central-tendencies and entropy measures etc. Also, correlations (synchronicity) between relative fluctuations over time and location in the brain may show networks with similar temporal temperature properties, which can be clearer biomarkers for tissue damage and thus potential (mental) disorders.

Further to the above-described proposal (to use MR thermometry to obtain an indication of brain tissue damage based on (relative) temperature fluctuations), it is also proposed that (absolute) MR thermometry may be used to obtain an indication of temperature elevations in the brain.

In particular, MR thermometry may be used for absolute temperature measurement(s) in the brain by employing an internal reference. Such an internal reference may, for example, be a brain metabolite that behaves differently from the water PRF with respect to temperature. Examples may include the PRF of one of: Creatine; Choline; NAA; and a non-water brain metabolite. Put another way, the internal reference may be one that behaves differently from the water PRF as function of the temperature. In the brain, NAA may be used, or other brain metabolites such as choline.

The metabolite NAA is suited for use as an internal reference, because NAA has a resonance frequency (methyl protons) which is different from the resonance frequency of the water protons. Additionally, these NAA protons have a different shift as function of the temperature compared to the water protons. Therefore, the difference of these resonance frequencies ($\delta_{H2O-NAA}$) can be used to determine the absolute temperature $T_{abs}$, as represented by equation 4:

$$T_{abs}= -102.7\delta_{H2O-NAA}+310.5 \qquad (4)$$

The absolute temperature $T_{abs}$ can then be compared between brain regions, and it can be assessed whether some brain regions have higher brain temperature than other. Further, it can be assessed (e.g. with the help of a look-up table) whether a temperature in a certain area of the brain is (substantially) higher than normally expected (from which an indication of brain tissue damage may be derived.

Thus, from the above description, it will be understood that a value of absolute temperature may be obtained based on a difference between the water PRF and an internal reference resonance frequency.

The concept for absolute temperature measurement of the brain may be combined with the proposed concept of obtaining an indication of brain tissue damage based on (relative) temperature fluctuations. Such a proposed combination of absolute and relative temperature assessment may provide detailed and accurate diagnostic information.

Accordingly, some proposed embodiments may combine the two previously described concepts of: (i) indicating brain tissue damage based on temperature fluctuations; and (ii) indicating brain tissue damage based on absolute temperature measurement. The combination of these two approaches may provide improved accuracy and certainty for determinations about the inflammatory status of a brain region. For example, in a strict implementation, a brain region may be indicated as being inflamed when both techniques indicate 2% difference from normal/expected value(s). In a more lenient implementation, a brain region may be indicated as being inflamed when at least one of both techniques indicates a 1% difference from normal/expected value(s).

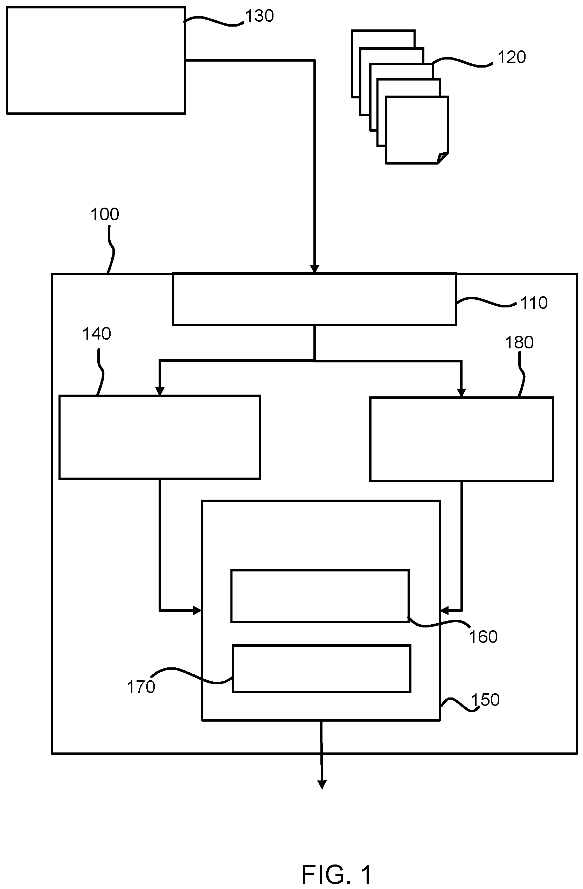

Referring now to Fig. 1, there is depicted a simplified block diagram of a system 100 for indicating tissue damage of a subject's brain according to an exemplary embodiment.

The system 100 comprises an interface component 110 that is configured to obtain a plurality of MRI images 120 of the subject's brain from an MRI apparatus 130. Here, the MRI images are all captured within an imaging time window, each MRI image being captured at a respective different time. By way of example, the MRI images of this embodiment are images of the subject's brain that have been recorded every 0.5 seconds over a time period (i.e. imaging time window) of 5 minutes.

A PRF component 140 of the system 100 is configured to analyse each of the plurality of MRI images 120 to determine, for each MRI image, the water PRF for a region of interest of the subject's brain. There are many known techniques for determining the water PRF and so a detailed explanation of a particular approach is omitted from this description. However, a commonly-used approach involves looking at the phase of the water signal in gradient-recalled echo (GRE) sequences (the phase changes if the resonance frequency changes, but measuring the phase is typically more accurate).

Information about the determined water PRFs for the plurlity of MRI images 120 is then provided to an analysis component 150 of the sytem 100.

The analysis component 150 is configured to determine a variation in the water PRF across the plurality of MRI images 120, and to then determine an indication of tissue damage of the region of interest of the subject's brain based on the determined variation in the water PRF. For instance, where the phase of the water signal is used, variations in the water PRF can be measured based on variations in the phase of the water signal in (GRE) sequences.

The determined indication of tissue damage of the region of interest of the subject's brain can then be output from the system 100, for example to a user and/or a clinical decision support system.

Specifically, in this emodiment, the analysis component 150 comprises a baseline calculation unit 160 that is configured to determine a baseline water PRF from the plurality of MRI images 120. Information about the the determined baseline water PRF is then provided to a processor 170 of the analysis component 150. The processor 170 is configured to determine a relative variation in the water PRF.

It is noted, however, that the embodiment of Fig. 1 also comprises a temperature component 180 that is configured to determine a value of absolute temperature of the region of interest of the subject's brain.

Here, the temperature component 180 determines, from the MRI images 120, a value of absolute temperature based on a difference between the waer PRF and an internal reference resonance frequency of NAA or Choline. It is, however, to be appreciated that an internal reference resonance frequency of other subtances may be employed, provided they exhibit different variations with respect to temperature than that of the water PRF. Preferably, the internal reference resonance frequency will be substantially independent of temperature.

Information about the determined value of absolute temperature of the region of interest of the subject's brain is provided to the analysis component 150. The analysis component 150 then determines an indication of tissue damage of the region of interest of the subject's brain further based on the determined value of absolute temperature.

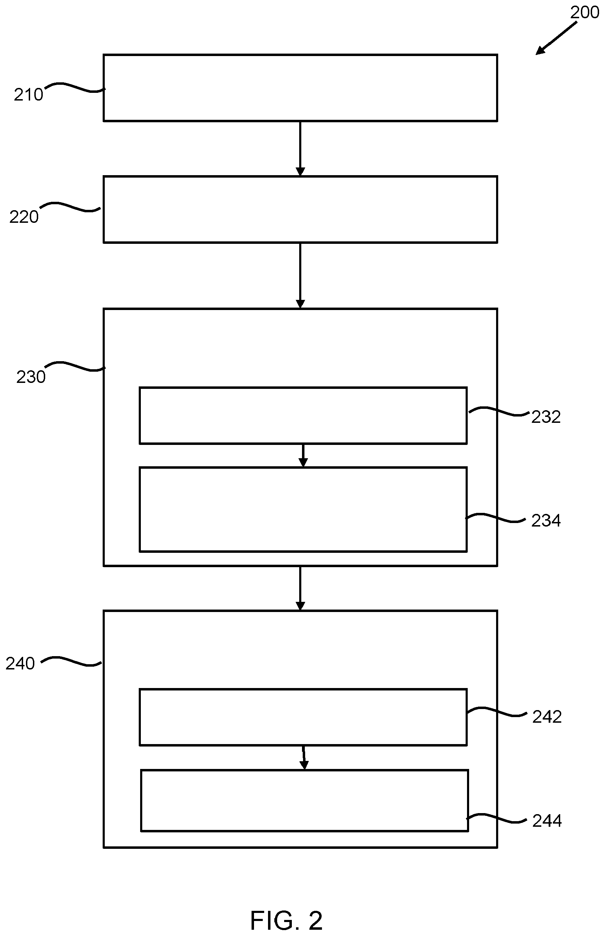

Referring now to Fig. 2, there is depicted a flow diagram of a method 200 for indicating tissue damage of a subject's brain according to an embodiment.

The method begins with obtaining 200 a plurality of MRI images of the subject's brain, for example from a remotely-located image database over the Internet. Each MRI image is captured at a different time within an imaging time window (such a 5, 10, 15 or 30 minute imagain time period).

Next, in step 220, for each of the plurality of MRI images, the water Proton PRF for a region of interest of the subject's brain is determined. Various known techniques for determining water PRF from an MRI image are known and it is envisaged that any such suitable PRF determination method may be employed in step 220.

The method then continues to step 230 of determining a variation in the water PRF across the plurality of MRI images. Specifically, step 230 of this embodiment comprises sub-steps 232 and 234. In step 232, a baseline water PRF for the plurality of MRI images is determined. In step 234, a relative variation in the water PRF with respect to the baseline water PRF. Specifically, in this exemplary embodiment step 234 of determining a relative variation in the water PRF comprises determining a maximum deviation of the water PRF across the plurality of MRI images.

Finally, in step 240, an indication of tissue damage in the region of interest of the subject's brain is determined based on the variation in the water PRF (determined in step 234). Specifically, step 240 of this exemplary embodiment comprises sub-steps 242 and 244.

Step 242 comprises comparing the determined variation in the water PRF against a variation threshold value. Here, the variation threshold value is subject-specific (i.e. based on at least one of characteristic or physiological property of the subject). In this way, subject-specific factors may be accounted to ensure that the maximum threshold value is set to an appropriate value. However, in other embodiments, the variation threshold value may not be subject-specific and may instead be the same for different subjects. Step 244 then comprises determining an indication of tissue damage in the region of interest of the subject's brain based on the comparison result. For instance, if the comparison result idenitfies that the dertemined variation in the water PRF exceeds the variation threshold value, it is inferred that brain region of interset exhibits inflammatory activity indicative of tissue damage. Converesly, if the comparison result idenitfies that the dertemined variation in the water PRF does not exceed the variation threshold value, it is inferred that brain region of interset does not exhibit excessive inflammatory activity.

Various aspects relating to potential embodiments will now be described in the following sections.

MR Imaging Technologies

In order to measure the temperature fluctuations, it is preferable that the plurality of MRI images has sufficient high temporal resolution, e.g. faster than the subject's heart rate. That is, it may be preferable to acquire MRI images of the brain that are successively captured at time intervals of less than one second, and preferably captured at a rate of two or more MRI images per second. Thus, fast MR acquisition and/or read-out schemes may be desirable, such as EPI read-out combined with parallel imaging and multislice excitation. Other, non-cartesian, readout schemes such as spiral may also be considered.

MR imaging sequences can be extended to include additional data acquisitions that can be used to improve the analysis. For example, multi-echo acquisition may be employed.

Post processing

It is proposed that temperature fluctuations are reflected as (local) variations of the water PRF. Such variations can cause differences in the phase and be measured as phase variations between subsequent acquisitions. These may be used to calculate the temperature change according to equation 5 as follows:

$$\Delta T = (\varphi(T) - \varphi(T_0)) / (\gamma \alpha B_0 TE) \qquad (5),$$

wherein: $\varphi(T)$ is the phase in the current image; $\varphi(T_0)$ is the baseline/reference phase; $\gamma$ is the gyromagnetic ratio; $\alpha$ is the PRF change coefficient; Bo is the magnetic field strength, and TE is the echo time.

Phase difference is dependent on the echo-time (TE). Therefore, acquiring multi-echo data, i.e. several echo-times for the same temporal time point, can be helpful to distinguish phase changes caused by temperature from phase changes caused by scanner imperfections.

It will be appreciated that proposed embodiments may be implemented in conjunction with existing MRI scanners. Embodiments may also be integrated with MRI scanner and MRI apparatus (either as hardware and/or software). Further, processing software implementing proposed embodiment may be provided for existing (and future) tool sets.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

A single processor or other unit may fulfill the functions of several items recited in the claims.

The mere fact that certain measures are recited in mutually different dependent claims does not indicate that a combination of these measures cannot be used to advantage.

A computer program may be stored/distributed on a suitable medium, such as an optical storage medium or a solid-state medium supplied together with or as part of other hardware, but may also be distributed in other forms, such as via the Internet or other wired or wireless telecommunication systems.

If the term "adapted to" is used in the claims or description, it is noted the term "adapted to" is intended to be equivalent to the term "configured to".

Any reference signs in the claims should not be construed as limiting the scope.

**Claims**

1. A method (200) for indicating tissue damage of a subject's brain, the method comprising:

   - obtaining (210) a plurality of MRI images of the subject's brain, each MRI image being captured at a different time within an imaging time window;
   - for each of the plurality of MRI images, determining (220) the water Proton Resonance Frequency, PRF, for a region of interest of the subject's brain;
   - determining (230) a variation in the water PRF across the plurality of MRI images; and
   - determining (240) an indication of tissue damage in the region of interest of the subject's brain based on the determined variation in the water PRF.

2. The method of claim 1, wherein determining (230) a variation in the water PRF comprises:

   - determining (232) a baseline water PRF for the plurality of MRI images; and
   - determining (234) a relative variation in the water PRF with respect to the baseline water PRF.

3. The method of claim 2, wherein determining (234) a relative variation in the water PRF comprises:
   determining a maximum deviation of the water PRF from the baseline water PRF across the plurality of MRI images.

4. The method of any of claims 1 to 3, wherein determining (240) an indication of tissue damage of the region of interest of the subject's brain comprises:

   - comparing (242) the determined variation in the water PRF against a variation threshold value; and
   - determining (244) an indication of tissue damage in the region of interest of the subject's brain based on the comparison result.

5. The method of claim 4, wherein the variation threshold value is based on at least one of: a characteristic of blood flow in the subject's brain; medication taken by the subject; the region of interest; a physiological property of the subject; a medical condition of the subject; a medical history of the subject.

6. The method of any of claims 1 to 5, further comprising:

   - determining a value of absolute temperature of the region of interest of the subject's brain, and
   - wherein determining an indication of tissue damage of the region of interest of the subject's brain is further based on the determined value of absolute temperature of the region of interest of the subject's brain.

7. The method of claim 6, wherein determining a value of absolute temperature of the region of interest comprises:
   determining a value of absolute temperature based on a difference between the water PRF and an internal reference resonance frequency.

8. The method of claim 7, wherein the internal reference resonance frequency comprises resonance frequency of one of: Creatine; Choline; NAA; and a non-water brain metabolite.

9. A computer program product comprising computer program code means which, when executed on a computing device having a processing system, cause the processing system to perform all of the steps of the method according to any of claims 1 to 8.

10. A system (100) for indicating tissue damage of a subject's brain, the system comprising:

    - an interface component (110) configured to obtain a plurality of MRI images of the subject's brain, each MRI image being captured at a different time within an imaging time window;
    - a Proton Resonance Frequency component (140) configured to, for each of the plurality of MRI images, determine the water Proton Resonance Frequency, PRF, for a region of interest of the subject's brain; and
    - an analysis component (150) configured to determine a variation in the water PRF across the plurality of MRI images, and to determine an indication of tissue damage of the region of interest of the subject's brain based on the determined variation in the water PRF.

11. The system of claim 10, wherein the analsyis component (150) comprises:

- a baseline calculation unit (160) configured to determine a baseline water PRF for the plurality of MRI images; and
- a processor (170) configured to determine a relative variation in the water PRF with respect to the baseline water PRF.

12. The system of claim 10 or 11, further compirising:

- a temperature component (180) configured to determine a value of absolute temperature of the region of interest of the subject's brain, and
- wherein the analysis component (150) is configured to determine an indication of tissue damage of the region of interest of the subject's brain further based on the determined value of absolute temperature of the region of interest of the subject's brain.

13. The system of claim 12, wherein the temperature component (1800 is configured to determine a value of absolute temperature based on a difference between the wtaer PRF and an internal reference resonance frequency.

14. The system of claim 13, wherein the internal reference resonance frequency comprises resonance frequency of one of: Creatine; Choline; NAA; and a non-water brain metabolite.

15. Magnetic Resonance Imaging apparatus comprising a system for according to any of claims 10 to 14.

FIG. 1

FIG. 2

Europäisches
Patentamt

European
Patent Office

Office européen
des brevets

# EUROPEAN SEARCH REPORT

Application Number

EP 20 19 2312

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/351261 A1 (LEVY YOAV [IL]) 21 November 2019 (2019-11-21) | 1-5, 9-11,15 | INV. G01R33/483 |
| Y | * paragraphs [0002] - [0004], [0006], [0009], [0030] - [0036], [0069] - [0073]; claim 1; figures 2,4-8 * | 6-8, 12-14 | G01R33/48 |
| X | KICKHEFEL A ET AL: "Accuracy of real-time MR temperature mapping in the brain: A comparison of fast sequences", PHYSICA MEDICA, ACTA MEDICA EDIZIONI E CONGRESSI, ROME, IT, vol. 26, no. 4, 1 October 2010 (2010-10-01), pages 192-201, XP027299851, ISSN: 1120-1797 [retrieved on 2010-09-18] * abstract * * figures 1-3 * | 1-5, 9-11,15 | |
| X | US 2014/309519 A1 (KONINK PHILIPS BV) 16 October 2014 (2014-10-16) * paragraphs [0001] - [0011], [0018] - [0030]; figures 2-4 * | 1-5, 9-11,15 | TECHNICAL FIELDS SEARCHED (IPC) G01R A61B |
| Y | MARSHALL I ET AL: "Measurement of regional brain temperature using proton spectroscopic imaging: validation and application to acute ischemic stroke", MAGNETIC RESONANCE IMAGING, ELSEVIER SCIENCE, TARRYTOWN, NY, US, vol. 24, no. 6, 1 July 2006 (2006-07-01), pages 699-706, XP028004856, ISSN: 0730-725X, DOI: 10.1016/J.MRI.2006.02.002 [retrieved on 2006-07-01] * 1. Introdiuction, 2. Methods, 3. Results; figures 1-4 * | 6-8, 12-14 | |

-/--

The present search report has been drawn up for all claims

| Place of search | Date of completion of the search | Examiner |
|---|---|---|
| Munich | 12 February 2021 | Faber-Jurk, Sonja |

EPO FORM 1503 03.82 (P04C01)

Europäisches
Patentamt

European
Patent Office

Office européen
des brevets

# EUROPEAN SEARCH REPORT

Application Number

EP 20 19 2312

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DEMIR CANER FEYZI ET AL: "Is it possible to detect active multiple sclerosis plaques using MR thermometry techniques?", MEDICAL HYPOTHESES, EDEN PRESS, PENRITH, US, vol. 80, no. 3, 9 January 2013 (2013-01-09), pages 321-324, XP028979861, ISSN: 0306-9877, DOI: 10.1016/J.MEHY.2012.12.019 * the whole document * ----- | 1-15 | |

**TECHNICAL FIELDS SEARCHED (IPC)**

The present search report has been drawn up for all claims

| Place of search | Date of completion of the search | Examiner |
|---|---|---|
| Munich | 12 February 2021 | Faber-Jurk, Sonja |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

........................................................................
& : member of the same patent family, corresponding
   document

EPO FORM 1503 03.82 (P04C01)

page 2 of 2

## ANNEX TO THE EUROPEAN SEARCH REPORT
## ON EUROPEAN PATENT APPLICATION NO.

EP 20 19 2312

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2021

| Patent document cited in search report | Publication date | Patent family member(s) | Publication date |
|---|---|---|---|
| US 2019351261 A1 | 21-11-2019 | CN 112204412 A<br>US 2019351261 A1<br>WO 2019220213 A1 | 08-01-2021<br>21-11-2019<br>21-11-2019 |
| US 2014309519 A1 | 16-10-2014 | BR 112014015668 A2<br>CN 104039218 A<br>EP 2797501 A1<br>JP 6392667 B2<br>JP 6466514 B2<br>JP 2015503381 A<br>JP 2017176876 A<br>RU 2014130771 A<br>US 2014309519 A1<br>WO 2013098690 A1 | 13-06-2017<br>10-09-2014<br>05-11-2014<br>19-09-2018<br>06-02-2019<br>02-02-2015<br>05-10-2017<br>20-02-2016<br>16-10-2014<br>04-07-2013 |

EPO FORM P0459

For more details about this annex : see Official Journal of the European Patent Office, No. 12/82